# EUROPÄISCHE PATENTSCHRIFT

(11) **EP 0 455 238 B1**
(45) Veröffentlichungstag und Bekanntmachung des Hinweises auf die Patenterteilung: **02.07.1997**
(21) Anmeldenummer: 91107103.3
(22) Anmeldetag: 30.04.1991
(51) Int. Cl.: G11C 16/00

(54) **Verfahren zur Verlängerung der Benutzungsdauer von Informationsträgern mit EEPROM**
Method for increasing the utilisation period of information carriers with EEPROM
Méthode pour augmenter la durée d'utilisation de porteurs d'informations comportant des EEPROM

(30) Priorität: 02.05.1990 DE 4014151
(43) Veröffentlichungstag der Anmeldung: 06.11.1991
(73) Patentinhaber: DeTeMobil Deutsche Telekom MobilNet GmbH, 53227 Bonn (DE)
(72) Erfinder: Weis, Klaus, 53757 Sankt Augustin (DE); Sinning, Richard, Dr., 52080 Aachen (DE)
(74) Vertreter: Riebling, Peter, Dr.-Ing., Patentanwalt

(56) Entgegenhaltungen:
- EP-A- 0 340 981
- WO-A-89/10618
- DE-A- 3 517 087
- GB-A- 2 094 229
- US-A- 4 763 305
- ELECTRONIC DESIGN. Bd. 31, Nr. 23, 10. November 1983, HASBROUCK HEIGHTS, NEW JERSEY, DAVE BURSKY:'64-kbit EEPROM to appear in CMOS'
- PATENT ABSTRACTS OF JAPAN vol. 6, no. 13 (P-99)(891) 26. Januar 1982 & JP-A-56 137 594
- PATENT ABSTRACTS OF JAPAN vol. 8, no. 68 (P-264)(1505) 30. März 1984& JP-A-58 215 794

## Beschreibung

Die Erfindung betrifft ein Verfahren zur Verlängerung der Benutzungsdauer von Informationsträgern, die einen elektrisch löschbaren programmierbaren Speicher (EEPROM) enthalten.

Informationsträgern, die unter anderem einen elektrisch löschbaren programmierbaren Speicher (EEPROM) enthalten, werden beispielsweise als Berechtigungsnachweis beim bargeldlosen Geldtransfer oder in der Informationsübertragung in der Weise eingesetzt, daß in dem genannten Speicher temporäre Daten, welche für den gerade stattfindenden Anwendungsfall speziell generiert worden sind, beim nächsten Fall jedoch keine Gültigkeit mehr haben, für eine gewisse Zeit gespeichert werden. Diese Speicherdauer kann kleiner sein als die Dauer der fallbezogenen Anwendung, so daß während einer Anwendung die temporären Daten mehrfach gewechselt werden können.

Aufgrund der durch die Technik der EEPROMS begrenzten Anzahl von Schreibvorgängen tritt das Problem auf, daß dadurch die Nutzungsdauer solch eines Informationsträgers stark eingeschränkt wird, da die restlichen Bauteile üblicherweise um Größenordnungen langlebiger sind.

Aus dem Stand der Technik sind verschiedene Verfahren zur Umgehung des Problems der begrenzten Schreibenanzahl bekannt. Aus dem US-Patent 4,763,305 ist es bekannt, das Ausführen eines Schreibzyklus in einem Informationsträger mit EEPROM davon abhängig zu machen, ob die bereits gespeicherte Information der einzuschreibenden Information gleicht. Ist die alte Information mit der neuen, einzuschreibenden Information identisch, wird der Speicher nicht neu beschrieben. Das hierin beschriebene Verfahren bildet den Oberbegriff des Patentanspruchs 1.

Aus der JP-A-56 137 594 ist ein Kontrollsystem für nicht flüchtige Speicher bekannt, bei dem direkt nach einem Schreibvorgang in den Speicher die eingeschriebenen Daten wieder ausgelesen werden und mit den geschriebenen Daten verglichen werden. Beim Erkennen eines Speicherfehlers wird der Schreibvorgang wiederholt, wobei bei wiederholtem, fehlerhaften Einschreiben in einen bereitgestellten Ersatzspeicherbereich geschrieben wird.

Die Offenlegungsschrift DE 35 17 087 A1 beschreibt ein Verfahren zur Vergrößerung der Maximalanzahl möglicher Programmier-Lösch-Zyklen eines Festwertspeichers, wobei die verfügbare Anzahl an Speicherplätzen mindestens doppelt so groß ist wie die benötigte Anzahl an Speicherplätzen. Die jeweiligen Programmier- und Löschzyklen werden gezählt. Bei Erreichen einer vorgegebenen Maximalanzahl wird auf einen Ersatzspeicherbereich gewechselt.

Der Erfindung liegt die Aufgabe zugrunde, die Benutzungsdauer eines Informationsträgers mit EEPROM wesentlich zu erhöhen ohne den Speicherumfang des EEPROMS wesentlich zu erweitern.

Die Aufgabe wird erfindungsgemäß durch die Merkmale des Patentanspruchs 1 gelöst, wobei die mittlere Schreibhäufigkeit für die stärker benutzten Speicherbereiche herabgesetzt wird.

Diese Reduzierung der Schreibvorgänge wird durch dadurch erreicht, daß vor jedem Schreibvorgang eine Prüfung darauf erfolgt, ob die neu einzuschreibenden Daten sich von den gespeicherten unterscheiden, wobei nur die Änderung neu gespeichert wird. Der häufig zu beschreibende Speicherteil, der üblicherweise nur einen geringen Teil des gesamten Speichers des EEPROMS ausmacht wird größer als erforderlich angelegt.

Unter Verwendung verschiedener Verfahren läßt sich die mittlere Schreibhäufigkeit in dem genannten Speicherteil reduzieren und so ebenfalls die Nutzungsdauer des Informationsträgers insgesamt erhöhen.

Vorteile beim Einsatz der Erfindung ergeben sich dadurch, daß durch die erhöhte Nutzungsdauer Kosten für den Austausch des Informtionsträgers eingespart werden. Bei gewissen Anwendungsfällen von Informationsträgern kann es außerdem für die Betriebssicherheit des Informationsaustausches erforderlich sein, nach dem Ausfall des ersten Speicherbereiches einen Ersatzspeicherbereich zur Verfügung stellen zu können, um eine Gefahrensituation abzuwenden.

Ein Ausführungsbeispiel der Erfindung wird im folgenden näher erläutert.

Bei einem digitalen Mobilfunktelefonsystem werden als Informationsträger Chipkarten verwendet, die ein EEPROM enthalten. Zu jeder Funkverbindung werden im Zuge des Verbindungsaufbaus temporäre Daten von der Funkfest-Station erzeugt und im Informationsträger der Mobilseite eine Zeit lang gespeichert. Diese temporären Daten werden bei jeder neuen Funkverbindung auf den neuesten Stand gebracht. Deshalb ergibt sich bezüglich dieser Daten eine hohe Schreibhäufigkeit, die die Nutzungsdauer der Chipkarte unerträglich klein hält.

Es ist zwar vorgesehen, bei einem Schreib/Lesedefekt der Chipkarte im Bereich der temporären Daten vom Mobilfunksystem auf einen Notbetrieb überzugehen. Jedoch führt der Notbetieb einer größeren Anzahl von Teilnehmern zu einem erhöhten Signalisierungsaufwand im Netz mit einer wachsenden Gefahr der Überlast.

Deshalb ist es schon allein aus Gründen des geordneten Betriebes des Mobilfunknetzes unerläßlich, die Zahl der defekten Chipkarten klein zu halten. Außerdem erhöht eine geringe Lebensdauer der Chipkarte in unerwünschter Weise die Kosten für den Teilnehmer eines solchen Dienstes.

Zu Beginn des Aufbaues einer Gesprächsverbindung zwischen einem Mobilfunktelefon und einer Funkfeststation wird eine Reihe von Daten ausgetauscht. Einige dieser Daten sind temporäre Daten, die nur für den gerade angenommenen Aufenthaltsort des Mobilfunktelefones gelten und bei jedem neuen Verbinddungsaufbau neu gespeichert werden. Um nun die Anzahl der Schreibvorgänge zu reduzieren, wird jedesmal wenn eine temporäre Information eintrifft, der Inhalt des Speicherbereichs für temporäre Daten gelesen und in einem Vergleicher mit der eintreffenden temporären Information verglichen.
Ist die eintreffende temporäre Information gleich der gelesenen Information des Speicherteiles, so erfolgt kein Schreibvorgang und die eintreffende temporäre Information wird nicht weiter verwendet.

Da es nicht auszuschließen ist, daß sich der Speicherinhalt eines EEPROMs seit dem letzten Schreibvorgang verändert hat - beispielsweise, wenn sich die einzelne Zelle dem Ende ihres Lebenszyklus nähert - wird zusätzlich zu jeder zu speicherden temporären Information noch eine Checksumme mit gespeichert.
Bei jedem Lesevorgang wird eine Paritätsprüfung durchgeführt, um festzustellen, ob eine Veränderung des Speicherinhaltes seit dem letzten Schreibvorgang aufgetreten ist. Beim Feststellen eines entsprechenden Speicherfehlers wird zur Bestätigung des Fehlers noch eine bestimmte Anzahl von Schreib- und Lesevorgängen durchgeführt. Wenn sich der Fehler bestätigt hat, wird eine diesbezügliche Alarmmeldung ausgegeben und der Teilnehmer aufgefordert, die Chipkarte dem Netzbetreiber zurückzugeben.

Erfindungsgemäß wirddie mittlere Schreibhäufigkeit für die Speicherzellen dadurch gesenkt , daß ein Speicherbereich, der größer als der für die temporären Daten benötigte Bereich ist, vorgesehen wird und daß die temporären Daten alternierend in den ersten und in einen zweiten Bereich geschrieben werden. Dadurch wird die Schreibhäufigkeit um den Faktor 2 reduziert. Falls noch mehr Speicherplatz vorhanden wäre, könnte auch ein Mehrfaches des ersten Speicherbereiches vorgesehen werden und dieser so zur Verfügung stehende Speicherplatz nach einem bestimmten Algorithmus beschrieben werden, angefangen vom zyklischen Schreiben. Bei Ausfall eines Teiles des Speicherbereiches würde dann der Algorithmus gewechselt, so daß der restliche Speicherplatz weiterbenützt werden würde.

In jedem Fall wäre es denkbar, nach dem Auftreten des ersten oder eines weiteren Fehlerfalles eine Warnmeldung an den Anwender der Chipkarte zu geben, damit er geeignete Maßnahmen vornehmen könnte.

Die Anwendung des erfindungsgemäßen Verfahrens zur Verminderung der Schreibhäufigkeit von Speichern ist natürlich nicht auf Chipkarten für Mobilfunkanwendungen beschränkt, sondern auf allen Gebieten einsetzbar, in denen die limitierte Schreibhäufigkeit von Speicherzellen eine Begrenzung darstellt, so beispielsweise im Bereich der Berechtigungskarten für Geldautomaten, für Verkehrssysteme, die Informationsträger verwenden, für Berechtigungskarten für Sicherheitssysteme jeglicher Art, für Verfahren zur Sicherung von Software gegen unberechtigtes Kopieren und oder Benutzen.

## Patentansprüche

1. Verfahren zu Verlängerung der Nutzungsdauer von Informationsträgern, die einen elektrisch löschbaren programmierbaren Speicher(EEPROM) enthalten, wobei vor dem Einschreiben einer ankommenden ersten Information in den genannten Speicherbereich ein Vergleich zwischen einer im genannten Speicherbereich vorhandenen zweiten Information und der ankommenden ersten Information durchgeführt wird und daß nur bei Ungleichheit der ersten und der zweiten Information die erste Information an die Stelle der zweiten Information in den genannten Speicherbereich geschrieben wird, **dadurch gekennzeichnet**, daß die Nutzinformation in einem größeren Speicherbereich abgelegt wird als theoretisch benötigt würde und dadurch die mittlere Schreibhäufigkeit reduziert wird, und daß der zum Schreiben von Informationen benutzte Bereich alternierend gewechselt wird.

2. Verfahren nach Patentanspruch 1, **dadurch gekennzeichnet,** daß in Verbindung mit einem Schreibvorgang eine Prüfung auf richtige Speicherung erfolgt und beim Erkennen eines Speicherfehlers dieser fehlerhafte Speicherbereich bei weiteren Speichervorgängen ausgelassen wird und nur noch der restliche intakte Speicherbereich benutzt wird.

## Revendications

1. Procédé pour augmenter la durée d'utilisation de supports d'informations qui contiennent une mémoire programmable effaçable électriquement (EEPROM), selon lequel, avant qu'une première information qui arrive ne soit enregistrée dans la zone de mémoire, une comparaison est effectuée entre une seconde information contenue dans ladite zone de mémoire et la première information qui arrive, et la première information n'est enregistrée dans la zone de mémoire à la place de la seconde que si les première et seconde informations sont différentes, **caractérisé** en ce que l'information utile est déposée dans une zone de mémoire qui est plus grande qu'il ne serait nécessaire théoriquement, ce qui réduit la fréquence d'enregistrement moyenne, et en ce que la zone utilisée pour l'enregistrement d'informations change en alternance.

2. Procédé selon la revendication 1, **caractérisé** en ce que, en liaison avec un enregistrement, on vérifie la mise en mémoire correcte et au cas où une erreur de mise en mémoire est détectée, on laisse cette zone de mémoire défectueuse, lors d'autres enregistrements, et on n'utilise plus que la zone de mémoire intacte qui reste.

## Claims

1. Method for extending the useful life of information carriers which contain an electrically erasable programmable memory (EEPROM), in which before the writing in of an incoming first piece of information into the said memory zone, a comparison is carried out between a second piece of information present in the said memory zone and the incoming first piece of information and that only when the first and second pieces of information are non-identical is the first piece of information written in place of the second piece of information into the said memory zone, characterised in that the useful information is deposited in a larger memory zone than would be theoretically required and thereby the average frequency of writing is reduced, and that the zone used for the writing of information is changed in an alternating manner.

2. Method according to Claim 1, characterised in that in connection with a writing process, an examination as to correct storage takes place and on recognition of a memory error, this faulty memory zone is omitted in further memory processes and only the remaining intact memory zone is used.
